# FASCICULE DE BREVET EUROPEEN

(11) **EP 3 041 797 B1**
(45) Date de publication et mention de la délivrance du brevet: **10.10.2018**
(21) Numéro de dépôt: 14755349.9
(22) Date de dépôt: 20.08.2014
(51) Int. Cl.: C03B 13/08, H01L 31/02, H01L 31/0236

(54) **FEUILLE DE VERRE TEXTURÉE À MOTIFS RECTILIGNES**
STRUKTURIERTE GLASSCHEIBE MIT GERADLINIGEN MERKMALEN
TEXTURED GLASS SHEET WITH RECTILINEAR FEATURES

(30) Priorité: 03.09.2013 BE 201300573
(43) Date de publication de la demande: 13.07.2016
(73) Titulaire: AGC Glass Europe, 1348 Louvain-la-Neuve (BE)
(72) Inventeur: SARTENAER, Yannick, B-5020 Vedrin (BE); LAMBRICHT, Thomas, B-1360 Perwez (BE); WAGEMANS, Fabrice, B-7141 Carnières (BE)
(74) Mandataire: Bayot, Daisy
(86) Numéro de dépôt international: PCT/EP2014/067704
(87) Numéro de publication internationale: WO 2015/032618

(56) Documents cités:
- FR-A1- 2 916 901
- US-A1- 2011 139 234
- US-A1- 2012 006 404

## Description

### 1. Domaine de l'invention

La présente invention concerne une feuille de verre texturée. En particulier, la présente invention concerne une feuille de verre texturée comprenant une première face munie d'une première texturation et une seconde face munie d'une seconde texturation. L'invention a également trait à l'utilisation d'une feuille de verre texturée comme substrat couvercle pour au moins un élément destiné à utiliser le rayonnement solaire disposé sous la feuille de verre.

Grâce à sa texturation particulière sur la première face, destinée en particulier à être positionnée du côté de la lumière incidente, la feuille de verre selon l'invention présente des propriétés améliorées de transmission de la lumière à travers ladite feuille, quelle que soit l'orientation de la lumière incidente, et des propriétés de « piégeage » de la lumière. De ce fait, la feuille de verre selon l'invention peut être avantageusement appliquée dans le domaine du photovoltaïque et, en particulier, être intégrée dans un panneau ou module solaire. Dans ce cas, la feuille de verre selon l'invention joue le rôle de couvercle/protection mécanique de la ou des cellule(s) photovoltaïque(s), est donc interposée entre le rayonnement solaire et l(a)esdite(s) cellule(s), et permet en conséquence un meilleur rendement du panneau/module solaire.

### 2. Solutions de l'art antérieur

Les modules photovoltaïques comportent en général des cellules solaires qui sont recouvertes d'un couvercle de verre. Ce couvercle, le plus souvent sous la forme d'une feuille de verre, permet de protéger les cellules du milieu extérieur (poussières, pluie, etc). Malheureusement, ce couvercle de verre génère une baisse de rendement du module du fait d'une diminution de la transmission du rayonnement solaire aux cellules, due à deux facteurs principaux : (i) des pertes en réflexion aux deux interfaces de la feuille de verre et (ii) des pertes dues à l'absorption du rayonnement quand il passe au travers du verre de la feuille.

Une des solutions connues pour augmenter le rendement d'un module photovoltaïque consiste à augmenter la transmission de la feuille couvercle positionnée entre les cellules et le rayonnement, en limitant la réflexion du rayonnement incident, via la présence d'une couche dite « antireflet » ou « anti-réfléchissante » et/ou via sa texturation, par exemple avec des motifs particuliers en relief par rapport à la surface de la feuille de verre et dirigés vers le rayonnement (et donc vers le milieu extérieur).

Différents motifs géométriques périodiques et en relief par rapport au plan général de la face texturée (concaves ou convexes) d'une feuille de verre ont déjà été décrits dans un tel contexte, notamment des pyramides, des cônes ou des demi-sphères. Plus précisément, la demande WO03/046617A1 décrit une plaque transparente comportant des motifs géométriques distribués périodiquement sur la face texturée de la plaque et permettant d'améliorer la transmission de la lumière de ladite plaque. Les motifs sont par exemple des cônes ou des pyramides à base polygonale (triangulaire ou carrée ou rectangulaire ou hexagonale ou octogonale), lesdits motifs pouvant être convexes, c'est-à-dire venant en excroissance/saillie par rapport au plan général de la face texturée, ou concaves, c'est-à-dire en creux dans la masse de la plaque. La demande WO03/054974A1, quant à elle, décrit une feuille de verre présentant des motifs concaves en forme de demi-sphère.

Toutefois, il est connu qu'une feuille de verre présentant ce type de motifs est sensible à l'encrassement et à la pollution. En particulier, lorsqu'une telle feuille de verre est intégrée dans un module solaire en tant que couvercle, les poussières amenées notamment par la pluie ou le vent se déposent sur la feuille et restent piégées dans les motifs eux-mêmes s'ils sont concaves ou dans les creux formés entre les motifs convexes. Cet encrassement est bien entendu fortement préjudiciable à la transmission énergétique et donc au rendement avec le temps du module solaire intégrant la feuille de verre ainsi texturée.

Une solution qui a été proposée à cet encrassement est de choisir une texturation présentant des motifs rectilignes, en forme de rainures ou des nervures, par exemple à section transversale sensiblement triangulaire ou trapézoïdale, s'étendant dans une seule direction et tout le long de la feuille. Dans le cas de tels motifs, il existe pour chaque couple de motifs adjacents un « chemin d'écoulement » entre les deux motifs, permettant à l'eau de pluie de s'écouler facilement dans le sens longitudinal des motifs et de s'évacuer aux extrémités correspondantes de la feuille. Cet écoulement est d'autant plus efficace que le module intégrant la feuille de verre texturée en tant que couvercle est monté en pente (l'eau s'écoule alors à une seule extrémité de chaque couple de motifs). Ces motifs permettent donc d'avoir une feuille de verre, couvercle d'un module solaire, qui présente en quelque sorte des propriétés « auto-nettoyantes ».

Toutefois, un problème connu qui se pose avec une feuille de verre comportant de tels motifs rectilignes s'étendant dans une seule direction et tout le long de la feuille est qu'elle est difficilement trempable. En effet, lors du traitement thermique nécessaire à la trempe, les feuilles comportant ces motifs se déforment, se fléchissent ou même ondulent, de façon irréversible. Elles ne sont alors plus du tout planes et donc inutilisables dans l'application solaire notamment. Un tel problème à la trempe est déjà décrit dans la demande WO2006134300A2.

Le document US2012/0006404 traite de cellules solaires intégrant des réseaux de diffraction et divulgue dans ce contexte une feuille de verre spécifiquement texturée sur ses deux faces par des motifs rectilignes. Toutefois, ce document n'est pas concerné par le problème connu de ce genre de texture lors de la trempe thermique ou lors de la manutention ou de la découpe de la feuille de verre. La texture de US2012/0006404 sert uniquement et de manière classique à donner de bonnes propriétés de piégeage de la lumière qui augmenteront l'efficacité de l'assemblage

Le document FR2916901A, quant à lui, traite d'un substrat en verre pour panneaux photovoltaïques, ledit substrat comportant une texturation sous forme de rainures parallèles sur ses deux faces principales (rainures pouvant être par exemple, de hauteur identique sur les deux faces). Il précise que la trempe thermique est facilitée si le substrat comprend une texturation supplémentaire en face extérieure. Toutefois, il ne considère pas les problèmes de manutention et de découpe qui surviennent alors (pour un substrat tel que celui de la figure 9 ou 11 de FR2916901A par exemple).
**3.** Pourtant, il y a clairement une demande dans le domaine du solaire afin de disposer d'un couvercle de verre, pour modules photovoltaïques, portant des motifs en relief lui conférant d'excellentes propriétés de transmission/piégeage de la lumière et une faible tendance à l'encrassement ou un nettoyage aisée, et qui soit trempable, c'est-à-dire sans déformation significative lors de la trempe thermique. De plus, il est également clairement demandé que ces couvercles de verre texturés puissent être manutentionnés facilement, à l'aide de systèmes classiques de manutention de feuille de verre (utilisant souvent des ventouses), et aussi qu'ils soient découpables aisément.

### Objectifs de l'invention

L'invention a ainsi notamment pour objectif de pallier ces inconvénients de l'art antérieur.

L'invention, dans au moins un de ses modes de réalisation, a ainsi pour objectif de fournir une feuille de verre texturée qui présente une bonne transmission de la lumière/énergétique, et en particulier, de bonnes propriétés de piégeage de la lumière, quelle que soit l'orientation de la lumière incidente.

Un autre objectif de l'invention, dans au moins un de ses modes de réalisation, est de fournir une feuille de verre texturée qui présente une faible tendance à l'encrassement.

Un autre objectif de l'invention, dans au moins un de ses modes de réalisation, a également pour objectif de fournir une feuille de verre texturée qui est trempable, c'est-à-dire sans déformation significative lors de la trempe thermique.

Finalement, l'invention, dans au moins un de ses modes de réalisation, a également pour objectif de fournir une feuille de verre texturée qui peut être manutentionnée et découpée aisément.

### 4. Exposé de l'invention

L'invention concerne une feuille de verre transparente comprenant :
- une première face munie d'une texturation 1 formée dans la masse du verre par une pluralité de motifs géométriques en relief, convexes par rapport au plan général de ladite face, rectilignes et parallèles entre eux s'étendant tout le long de ladite face et répartis sur l'ensemble de ladite face, et
- une seconde face munie d'une texturation 2 formée dans la masse du verre par une pluralité de motifs géométriques en relief, concaves par rapport au plan général de ladite face, rectilignes et parallèles entre eux s'étendant tout le long de ladite face et répartis sur l'ensemble de ladite face.

Conformément à l'invention les motifs de la texturation 2 sont tels que :
(i) le rapport de la hauteur h₂ des motifs de la texturation 2 sur la dimension b₂ de leur base est tel que 0,05 ≤ h₂/b₂ ≤ 2 ;
(ii) le rapport de la hauteur h₂ des motifs de la texturation 2 sur la hauteur h₁ des motifs de la texturation 1 est tel que : 0,5 ≤ h₂ ≤ h₁ ≤ 2;
(iii) le rapport du nombre n₂ de motifs de la texturation 2 sur le nombre n₁ de motifs de la texturation 1 est tel que : n₂/n₁ ≥ 0,1 et n₂/n₁<0,5.

Ainsi, l'invention repose sur une approche tout à fait nouvelle et inventive car elle permet de solutionner les inconvénients de l'art antérieur précités et de résoudre le problème technique posé. Les inventeurs ont en effet mis en évidence qu'il était possible, en utilisant un dessin à motifs rectilignes et parallèles sur une première face et un « contre-dessin » particulier sur la face opposée, d'obtenir une feuille de verre qui est trempable, même avec des motifs rectilignes sur la première face de taille conséquente par rapport à l'épaisseur du verre. La feuille de verre selon l'invention, texturée sur ses deux faces, peut de plus être manutentionnée aisément et découpée. En effet, les caractéristiques de nombre et d'espacement du « contre-dessin » selon l'invention, en relation avec les motifs sur la première face, permettent l'aménagement de portions de surface dénuées de motifs linéaires et dès lors sensiblement planes permettant une bonne accroche des ventouses des systèmes de manutention et le positionnement des roulettes de découpe. Finalement, du fait de la présence uniquement de motifs rectilignes, que ce soit sur l'une des faces ou sur l'autre, la feuille de verre selon l'invention présente une faible tendance à l'encrassement.

D'autres caractéristiques et avantages de l'invention apparaîtront plus clairement à la lecture de la description suivante d'un mode de réalisation préférentiel, donné à titre de simple exemple illustratif et non limitatif, et des figures annexées, parmi lesquelles :
La figure 1 illustre schématiquement, en perspective et isolément, des exemples de motifs rectilignes selon l'invention;
La figure 2 illustre schématiquement et en coupe des exemples d'assemblages de motifs selon l'invention ;
La figure 3 illustre schématiquement et en perspective une feuille de verre selon l'invention;
La figure 4 présente schématiquement et en coupe des exemples de configurations de feuille de verre selon l'invention.

Dans l'ensemble du présent texte, lorsqu'une gamme est indiquée, les extrémités sont incluses. En outre, toutes les valeurs entières et sous-domaines dans les gammes numériques sont expressément incluses comme si explicitement écrites. Dans l'ensemble du présent texte également, les valeurs de teneur en pourcentages sont des valeurs pondérales, exprimées par rapport au poids total du verre.

La feuille de verre selon l'invention est faite de verre pouvant appartenir à diverses catégories. Le verre peut ainsi être un verre de type silico-sodo-calcique, un verre de type alumino-silicate, un verre au bore, un verre au plomb, etc.

Selon un mode de réalisation préféré, la feuille de verre est faite d'un verre de type silico-sodo-calcique. Selon ce mode de réalisation, le verre peut avoir une composition qui comprend en une teneur exprimée en pourcentages en poids total de verre :

| | |
|---|---|
| SiO₂ | 60 - 78% |
| Al₂O₃ | 0 - 5% |
| B₂O₃ | 0 - 5% |
| CaO | 0 - 16% |
| MgO | 0 - 10% |
| Na₂O | 5 - 20% |
| K₂O | 0 - 10% |
| BaO | 0 - 5%. |

Selon l'invention, la composition de la feuille de verre peut comprendre, en plus des impuretés contenues notamment dans les matières premières ou d'éléments provenant de la dissolution des réfractaires constituant les fours de fusion, un ou plusieurs additif(s) réparti(s) de manière homogène dans sa masse, tels que, par exemple, un composé oxydant, un agent régulateur de la viscosité et/ou un agent facilitant la fusion ou l'affinage.

Par une face d'une feuille de verre, on entend l'une des deux faces/surfaces principales de la feuille.

Selon l'invention, par feuille de verre transparente, on entend une feuille de verre qui transmet au moins partiellement la lumière. Avantageusement, la feuille de verre transparente selon l'invention transmet au moins partiellement le rayonnement solaire dans les domaines de longueurs d'onde utiles pour les éléments destinés à utiliser le rayonnement solaire du dispositif dans lequel la feuille est destinée à être intégrée en tant que substrat couvercle. Par exemple, dans le cas d'un module photovoltaïque comprenant des cellules photovoltaïques à base de silicium polycristallin, la feuille de verre de l'invention est avantageusement transparente dans le domaine de longueurs d'onde comprises entre 400 nm et 1200 nm.

La feuille de verre selon l'invention a de préférence une transmission énergétique (TE), pour une épaisseur de 3,85 mm, d'au moins 89%. Avantageusement, la feuille de verre selon l'invention a une transmission énergétique (TE), pour une épaisseur de 3,85 mm, d'au moins 90%, et mieux encore, d'au moins 91%.

La feuille de verre selon l'invention a de préférence une transmission lumineuse, mesurée avec l'illuminant D65 (TLD), selon la norme ISO9050 et pour une épaisseur de 3,85 mm, d'au moins 90,5 %.

Selon un mode de réalisation de l'invention, la feuille de verre est avantageusement faite d'un verre à basse teneur en fer. Par verre à basse teneur en fer, on entend une verre dont la composition comprend une teneur totale en fer (exprimée en terme de Fe₂O₃) inférieure à 0,06% en poids par rapport au poids total du verre. Le fer étant un élément absorbant, cette valeur maximale de teneur en fer permet de limiter les pertes dues à l'absorption du rayonnement quand il passe au travers du verre et donc, d'augmenter la transmission énergétique de la feuille de verre. De manière préférée, la feuille de verre est faite d'un verre dont la composition comprend une teneur en fer total (exprimée sous forme de Fe₂O₃) allant de 0,002 à 0,04% en poids par rapport au poids total du verre. De manière toute préférée, la feuille de verre est faite d'un verre dont la composition comprend une teneur en fer total (exprimée sous forme de Fe₂O₃) allant de 0,002 à 0,02% en poids par rapport au poids total du verre. Une teneur en fer total (exprimée sous forme de Fe₂O₃) inférieure ou égale à 0,02% en poids permet d'augmenter davantage la transmission énergétique de la feuille de verre. La valeur minimale permet de ne pas trop pénaliser le coût du verre car de si faibles valeurs en fer nécessitent souvent des matières premières très pures onéreuses ou bien une purification de celles-ci.

Selon un autre mode de réalisation préférentiel, la feuille de verre est faite d'un verre dont la composition comprend une teneur en antimoine (exprimée sous forme de Sb₂O₃) de 0,005 à 0,5 % en poids par rapport au poids total du verre.

Selon un autre mode de réalisation de l'invention, la feuille de verre est faite d'un verre dont la composition présente un rédox allant de 0,01 à 0,4. Le degré d'oxydation d'un verre est donné par son rédox, défini comme le rapport en poids d'atome de Fe²⁺ par rapport au poids total des atomes de fer présents dans le verre, Fe²⁺/Fe total. Cette gamme de rédox permet d'obtenir des propriétés optiques très satisfaisantes et en particulier, en termes de transmission énergétique. De préférence, la composition présente un rédox de 0,03 à 0,3. De manière toute préférée, la composition présente un rédox de 0,05 à 0,25.

La feuille de verre selon l'invention peut avoir des dimensions diverses, par exemple supérieure à 1 m x 0,5 m. La feuille de verre selon l'invention peut avoir une épaisseur variant entre 0,1 et 20 mm. Avantageusement, dans le cas de l'utilisation en tant que couvercle protecteur d'un module photovoltaïque, la feuille de verre selon l'invention a une épaisseur e allant de 1 à 6 mm et de préférence, de 1,8 à 4,5 mm.

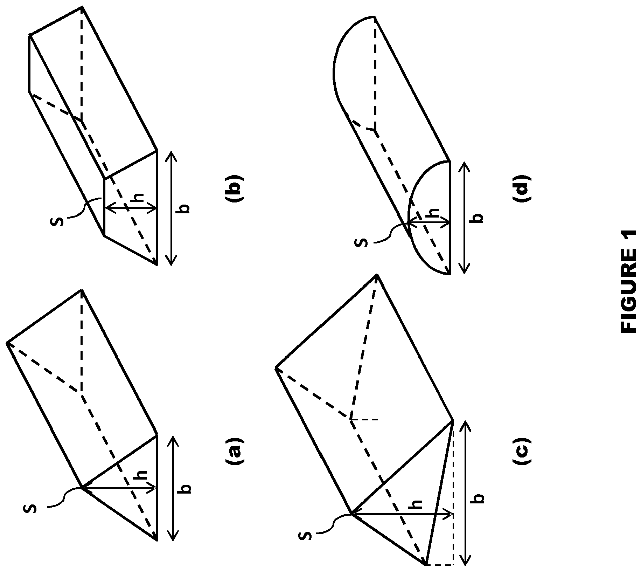

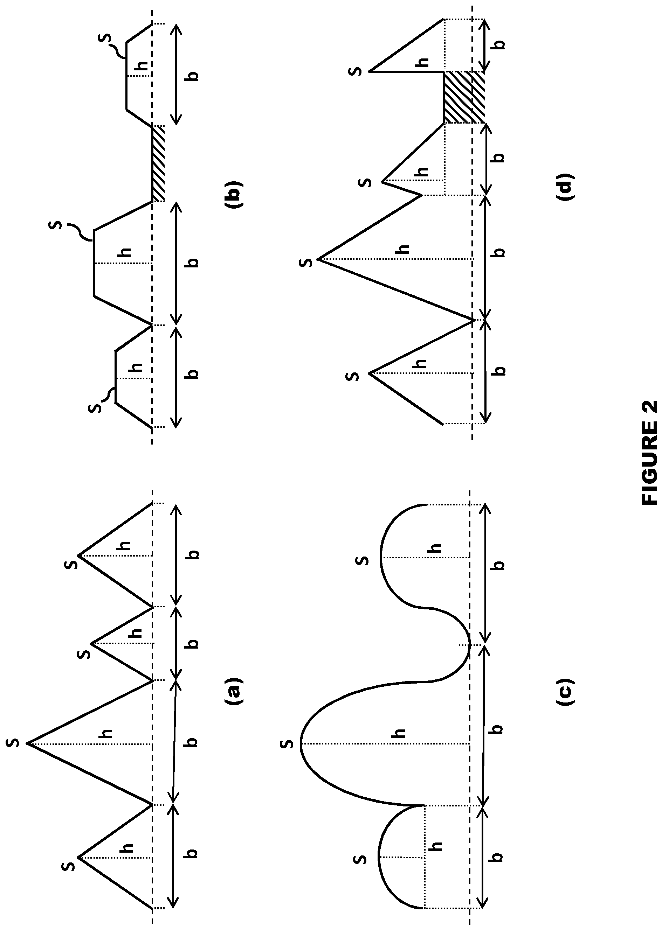

Selon l'invention, la pluralité de motifs géométriques en relief de la texturation 1 et/ou 2 sont rectilignes et parallèles entre eux, s'étendant tout le long de ladite face. Un motif rectiligne comprend une section de forme géométrique quelconque étendue spatialement selon un axe perpendiculaire au plan de ladite section, chaque section comportant une base, un sommet et une hauteur déterminée à partir dudit sommet. Chaque motif peut ainsi être caractérisé par sa section, ou par le sommet S, la hauteur h et la base b de cette section. Des exemples de motifs rectilignes selon l'invention sont montrés, en perspective et isolément, à la figure 1. Des exemples d'assemblages de motifs selon l'invention sont montrés en coupe à la figure 2. Les notions de base b, de sommet S et de hauteur h ont illustrées à l'aide des exemples des figures 1 et 2. En particulier, pour ce qui est de la définition de la base, et pour lever toute ambiguïté pour certains cas particuliers, la base doit être considérée comme la projection de la section d'un motif sur le plan général de la face concernée, comme illustré aux figures 1(c) et 2(c), (d). De même, pour ce qui est de la définition de la hauteur, et pour lever également toute ambiguïté pour certains cas particuliers, la hauteur doit être considérée comme la distance verticale entre le point le plus haut et le point le plus bas de la section, comme illustré aux figures 1(c) et 2(c), (d). Finalement, une zone sensiblement plane sur une face (voir zone hachurée sur la figure 2 (b) et (d)) ne constitue pas ou ne fait pas partie des motifs, à l'exception du cas où ladite zone constitue le sommet d'un motif (voir figures 1(b) et 2(b)).

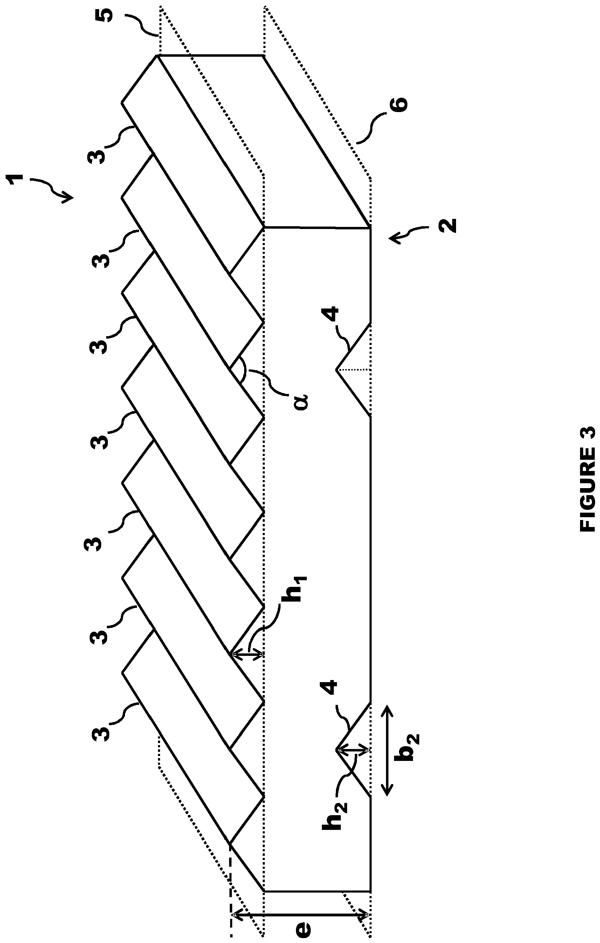

L'épaisseur e de la feuille de verre est définie selon l'invention telle qu'illustrée à la figure 3 qui représente, en perspective, une feuille de verre selon l'invention présentant une première face (1) munie de la texturation 1 et une seconde face (2) munie de la texturation 2. L'épaisseur e inclut la hauteur h₁ et h₂ des motifs de chacune des faces.

Selon l'invention, les motifs (3) de la texturation 1 sont convexes. Selon l'invention, les motifs (4) de la texturation 2 sont concaves. Un motif rectiligne en relief et convexe par rapport au plan général d'une face d'une feuille de verre est en saillie par rapport à ce plan et on peut alors parler de « nervures ». Selon l'invention, un motif rectiligne en relief et concave par rapport au plan général d'une face d'une feuille de verre est en creux dans la masse du verre, et on peut alors parler de «rainures ». En conséquence, et pour lever toute ambiguïté, dans les figures 1 et 2, il est bien entendu que, si on considère un motif comme convexe (texturation 1), les motifs représentés sont constitués de verre. Par opposition, si on considère un motif comme concave (texturation 2), les motifs représentés sont alors immatériels.

La notion de plan général (5, 6) d'une face est illustrée aux figures 2 et 3. Le plan général (5) de la face texturée 1 est le plan sensiblement parallèle au plan général de la feuille de verre, continu sur l'ensemble de ladite feuille (c'est-à-dire non traversé par un motif) et le plus éloigné de la face opposée. Le plan général (6) de la face texturée 2 est le plan sensiblement parallèle au plan général de la feuille de verre, contenant le point appartenant à la feuille de verre le plus éloigné de la face opposée. Selon l'invention, le plan général d'une face est sensiblement parallèle au plan général de la face opposée.

Selon l'invention, le nombre n de motifs sur une face est déterminé en comptant chacun des motifs individuels selon l'invention ou alternativement, en comptant le nombre de sommets (puisque définissant chacun un et un seul motif).

Selon un autre mode de réalisation de l'invention, le rapport de la hauteur h₂ des motifs de la texturation 2 sur la dimension b₂ de leur base est tel que 0,1 ≤ h₂/b₂ ≤ 1. Ceci présente l'avantage d'encore diminuer les déformations observées de la feuille de verre après trempe thermique.

Selon l'invention, le rapport de la hauteur h₂ des motifs de la texturation 2 sur la hauteur h₁ des motifs de la texturation 1 est tel que 0,5 ≤ h₂/h₁ ≤ 2. Ceci présente l'avantage d'encore diminuer les déformations observées de la feuille de verre après trempe thermique, tout en garantissant une résistance mécanique suffisante de la feuille. De préférence, le rapport de la hauteur h₂ des motifs de la texturation 2 sur la hauteur h₁ des motifs de la texturation 1 est tel que 0,5 ≤ h₂/h₁ ≤ 1.

Selon l'invention, le rapport du nombre n₂ de motifs de la texturation 2 sur le nombre n₁ de motifs de la texturation 1 est tel que n₂/n₁ ≥ 0,1. Ceci présente l'avantage d'encore diminuer les déformations observées de la feuille de verre après trempe thermique. De préférence, le rapport du nombre n₂ de motifs de la texturation 2 sur le nombre n₁ de motifs de la texturation 1 est tel que n₂/n₁ ≥ 0,2.

Selon l'invention, le rapport du nombre n₂ de motifs de la texturation 2 sur le nombre n₁ de motifs de la texturation 1 est tel que n₂/n₁ ≤ 0,5. Une telle borne supérieure permet l'aménagement de portions de surface dénuées de motifs linéaires sur la face munie de la texturation 2 et dès lors sensiblement planes permettant une bonne accroche des ventouses des systèmes classiques de manutention de feuille de verre et le positionnement aisé des roulettes de découpe sur ladite face. De préférence, le rapport du nombre n₂ de motifs de la texturation 2 sur le nombre n₁ de motifs de la texturation 1 est tel que n₂/n₁ ≤ 0,3.

Selon un mode de réalisation de l'invention, le rapport R₁ de la hauteur h₁ des motifs de la texturation 1 sur l'épaisseur e de la feuille de verre est tel que 0,1 < R₁ ≤ 0,30. Une telle gamme permet d'atteindre de très bonnes performances en terme de piégeage de la lumière. De préférence, le rapport R₁ de la hauteur h₁ des motifs de la texturation 1 par rapport au plan général de la face munie de la texturation 1 sur l'épaisseur e de la feuille de verre est tel que 0,1 < R₁ ≤ 0,15.

Selon un autre mode de réalisation de l'invention, le rapport R₁ de la hauteur h₁ des motifs de la texturation 1 sur l'épaisseur e de la feuille de verre est de 0,002 ≤ R₁ ≤ 0,10. Une telle limite supérieure permet de limiter la déformation observée lors de la trempe, induite par la texturation 1. La limite inférieure permet de maintenir un effet de piégeage de la lumière significatif sur la face munie de la texturation 1.

De préférence, les motifs de la texturation 1 sont les plus proches possible les uns des autres. Ils sont par exemple espacés de moins de 2 mm, et de préférence de moins de 1 mm. De manière toute préférée, les motifs sont jointifs. Ceci est avantageux car la densité de texturation est alors maximisée au profit de la transmission. Par motifs jointifs, on entend des motifs qui se touchent en au moins une partie de leur surface, par exemple via une arête dans le cas de motif rectiligne et parallèle.

Selon un mode de réalisation de l'invention, la face de la feuille de verre munie de la texturation 1 est texturée sur seulement une partie de sa surface. Alternativement et de manière préférée, la face de la feuille de verre munie de la texturation 1 est texturée sur une majorité de sa surface. Par une majorité de la surface de la face texturée, on entend au moins 80% de la surface, voire au moins 90% de la surface. Ceci est aussi avantageux en terme de densité de texturation.

Selon l'invention, les motifs de la texturation 1 peuvent être différents ou tous identiques en terme de géométrie et/ou en terme de taille. Dans le cas où plusieurs types de motifs (taille/géométrie) co-existent, pour la détermination de la hauteur h₁ des motifs de la texturation 1 et de l'épaisseur de la feuille e, on considère selon l'invention les motifs de la texturation 1 couvrant la plus grande surface de la feuille.

Selon un mode de réalisation préféré de l'invention, les motifs géométriques de la texturation 1 sont des prismes. Par prisme, on entend un polyèdre ayant deux faces polygonales parallèles dont les sommets sont joints 2 à 2 par des arêtes, formant les faces latérales qui sont des parallélogrammes. De manière préférée, selon ce mode de réalisation, les motifs géométriques sont des prismes triangulaires. Par prisme triangulaire, on entend un prisme dont les deux faces polygonales parallèles sont des triangles, Pour le cas où les motifs ont la forme de prismes triangulaires, le prisme triangulaire peut être tronqué, sans sortir du cadre de la présente invention. Une telle troncature consiste à raboter l'arête supérieure du prisme triangulaire (c'est-à-dire celle qui ne fait pas partie du plan général de la feuille). Dans ce cas, les faces triangulaires initiales du prisme deviennent trapézoïdales.

Toujours pour le cas où les motifs de la texturation 1 ont la forme de prismes triangulaires, l'angle α au sommet (voir Figure 3) est de préférence entre 60 et 120° pour chaque motif individuel.

Selon l'invention, dans le cas d'une feuille de verre de forme carrée ou rectangulaire, l'axe principal des motifs rectilignes et parallèles de la texturation 1 peut former un angle de 90° avec deux des bords de la feuille et de 0° avec les deux autres. Alternativement, les angles formés entre l'axe principal des motifs rectilignes et parallèles et deux des bords de la feuille peuvent prendre toutes valeurs comprises entre 0 et 90°. L'angle formé entre cet axe principal et les deux autres bords de la feuille est alors l'angle complémentaire du précédent.

Selon l'invention et indépendamment des motifs de la texturation 1, les motifs de la texturation 2 peuvent être différents ou tous identiques en terme de géométrie et/ou en terme de taille. Dans le cas où plusieurs types de motifs (taille/géométrie) co-existent, pour la détermination de la hauteur h₂ des motifs de la texturation 2, on considère selon l'invention les motifs de la texturation 2 ayant la plus grande hauteur, en dehors de toute considération de motif marginal.

Selon un mode de réalisation préféré de l'invention et indépendamment des motifs de la texturation 1, les motifs de la texturation 2 sont répartis uniformément sur l'ensemble de la face. Par uniformément, on entend que les motifs de la texturation 2 sont équidistants les uns des autres.

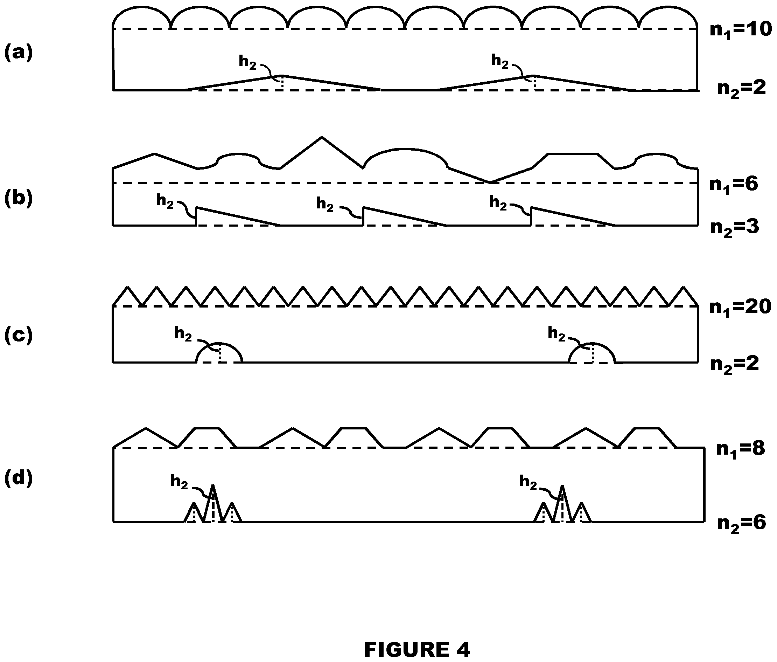

Selon un mode de réalisation préféré de l'invention et indépendamment des motifs de la texturation 1, les motifs de la texturation 2 sont isolés. Par motif isolé, on entend un motif qui ne possède aucun motif voisin jointif. Alternativement, selon un autre mode de réalisation, ils peuvent également être regroupés en assemblage de plusieurs motifs, comme illustré à la figure 4(d), lesdits assemblages étant alors isolés et répartis sur l'ensemble de la face. De préférence, selon ce dernier mode de réalisation, lesdits assemblages sont isolés et répartis uniformément sur l'ensemble de la face. Lorsque la face comporte des motifs ou des assemblages isolés, lesdits motifs ou assemblage sont séparés par des zones sensiblement planes. Selon un mode de réalisation particulier, les zones sensiblement planes peuvent présenter une texturation non linéaire et plus fine (par exemple, obtenue via une texturation à l'acide ou du type Solite™ ou Solatex™ produits par AGC Glass). Cette texturation plus fine présente l'avantage de faciliter le processus d'encapsulation dans la résine (par exemple, de l'EVA). Bien entendu, cette texturation ne doit pas entrer en compte dans la détermination des paramètres de l'invention (h, b, n).

Selon un autre mode de réalisation préféré de l'invention et indépendamment des motifs de la texturation 1, les motifs de la texturation 2 sont des prismes. De manière préférée, selon ce mode de réalisation, les motifs géométriques sont des prismes triangulaires. Pour le cas où les motifs ont la forme de prismes triangulaires, le prisme triangulaire peut être tronqué, sans sortir du cadre de la présente invention. Une telle troncature consiste à raboter l'arête supérieure du prisme triangulaire (c'est-à-dire celle qui ne fait pas partie du plan général de la feuille). Dans ce cas, les faces triangulaires initiales du prisme deviennent trapézoïdales.

Selon l'invention, dans le cas d'une feuille de verre de forme carrée ou rectangulaire, l'axe principal des motifs rectilignes et parallèles de la texturation 2 peut former un angle de 90° avec deux des bords de la feuille et de 0° avec les deux autres. Alternativement, les angles formés entre l'axe principal des motifs rectilignes et parallèles et deux des bords de la feuille peuvent prendre toutes valeurs comprises entre 0 et 90°. L'angle formé entre cet axe principal et les deux autres bords de la feuille est alors l'angle complémentaire du précédent.

Avantageusement, l'axe des motifs rectilignes de la texturation 1 forme un angle inférieur à 30° avec l'axe des motifs rectilignes de la texturation 2. De manière préférée, l'axe des motifs rectilignes de la texturation 1 forme un angle inférieur à 15° avec l'axe des motifs rectilignes de la texturation 2. De manière toute préférée, l'axe des motifs rectilignes de la texturation 1 est sensiblement parallèle avec l'axe des motifs rectilignes de la texturation 2.

La figure 4 (a) à (d) représente schématiquement, sous forme de coupe transversale de la feuille de verre, plusieurs configurations possibles pour les motifs de la texturation 1 et 2 selon l'invention, à titre d'exemples, en plus de la configuration de la figure 3 (le plan général pour chaque face étant représenté en pointillé).

La texturation 1 et /ou 2 de la feuille de verre de l'invention peut être réalisée par laminage, gravure, thermoformage, etc. Avantageusement, les texturations 1 et 2 de la feuille de verre de l'invention sont obtenues par laminage de la surface d'une feuille de verre, le verre étant à une température à laquelle il est possible de déformer sa surface, par exemple à l'aide de deux rouleaux métalliques ayant à leur surface les motifs de la texturation 1 ou 2 en négatif. Avec cette méthode de texturation, des motifs présentant des faces planes et des arêtes acérées sont très difficiles à obtenir, notamment du fait de leur petite taille. Les motifs formés ne présentent donc pas des formes géométriques parfaites. Ainsi, selon l'invention, le sommet de chaque motif et les creux encadrant chaque motif peuvent être plus ou moins légèrement arrondis, sans sortir du cadre de la présente invention.

La feuille de verre selon l'invention peut avantageusement être trempée thermiquement. En particulier, elle est capable de supporter le traitement de chauffe et de refroidissement rapide nécessaire à la trempe thermique. Classiquement, la feuille de verre doit dans un premier temps être chauffée quelques instants au-dessus de sa température de transition vitreuse. Ensuite, la feuille de verre est refroidie très rapidement, par exemple à l'aide d'une soufflerie d'air puissante. La vitesse de refroidissement du matériau est ainsi plus rapide en surface qu'au coeur, ce qui engendre des contraintes résiduelles importantes. La surface du verre est fortement mise en compression alors que le coeur se trouve dans un état de traction lorsque la feuille de verre retourne à la température ambiante. Cette combinaison d'états de contraintes permet d'une part de renforcer le verre, puisqu'il faut vaincre les contraintes de compression en surface avant de pouvoir solliciter les faces en traction et amener la rupture du matériau, et d'autre part d'obtenir un verre dit « de sécurité », puisque les contraintes de traction à coeur engendre une fragmentation fine du matériau lors de la rupture.

La feuille de verre selon l'invention ne présente pas de déformation significative après le traitement de trempe thermique. La déformation d'une feuille de verre trempée, également parfois appelée la « flèche, est classiquement mesurée le long des deux dimensions principales de la feuille de verre. On distingue dès lors deux « flèches » : selon un axe principal, et son perpendiculaire. La « flèche » est usuellement définie comme la longueur maximale d'un segment formé par les intersections d'une droite perpendiculaire à la droite joignant deux coins consécutifs de cette feuille avec (i) ladite droite joignant les deux coins consécutifs et (ii) la surface effective de la feuille de verre. On considère en général que la feuille subit une déformation acceptable si les « flèches » sont toutes deux inférieures ou égales à 3 mm par mètre de feuille de verre.

La feuille de verre selon l'invention peut également être renforcée chimiquement. Le renforcement chimique peut être réalisé grâce à l'échange ionique d'un ion alcalin présent dans la composition initiale du verre par un autre ion alcalin, de rayon ionique plus important et provenant d'un milieu extérieur au verre (bain de sel fondu, par exemple). Cet échange à la surface du verre génère des contraintes de compression importantes, permettant de renforcer considérablement la feuille de verre.

La feuille de verre selon l'invention peut également être durcie. Par durcissement, on entend le renforcement mécanique de la feuille de verre par un traitement semblable à celui de la trempe thermique, à la différence que les contraintes engendrées sont inférieures et ne permettent en particulier pas d'obtenir un verre de sécurité, à fragmentation fine.

La feuille de verre selon l'invention peut également comporter une ou plusieurs couche(s), sur la face munie de la texturation 1 et/ou sur le face opposée munie de la texturation 2, de nature appropriée à l'application visée/la propriété recherchée.

Selon un mode de réalisation de l'invention, la feuille de verre est revêtue d'au moins une couche mince transparente et conductrice de l'électricité. Ce mode de réalisation est avantageux pour des applications photovoltaïques. Lorsque la feuille de verre est utilisée comme couvercle protecteur d'un module photovoltaïque, la couche mince transparente et conductrice est disposée en face interne, c'est-à-dire entre la feuille de verre et les cellules solaires (cette face interne est également la face munie de la texturation 2). Une couche mince transparente et conductrice selon l'invention peut, par exemple, être une couche à base de SnO₂:F, de SnO₂:Sb ou d'ITO (oxyde d'indium et d'étain), ZnO:Al ou encore ZnO:Ga.

Selon un autre mode de réalisation de l'invention, la feuille de verre est revêtue d'au moins une couche antireflet (ou anti-réfléchissante). La couche antireflet peut être placée sur la face munie de la texturation 1 et/ou sur la face munie de la texturation 2. Ce mode de réalisation est avantageux dans le cas des applications photovoltaïques afin de maximiser la transmission énergétique de la feuille de verre et, par exemple, d'augmenter ainsi l'efficacité du module solaire comportant cette feuille en tant que substrat (ou couvercle) recouvrant des cellules photovoltaïques. Dans des applications dans le domaine solaire (photovoltaïque ou thermique), lorsque la feuille de verre est utilisée comme couvercle protecteur, la couche antireflet est déposée préférentiellement en face externe, c'est-à-dire côté ensoleillement, et donc sur la face munie de la texturation 1. Une couche antireflet selon l'invention peut, par exemple, être une couche à base de silice poreuse à bas indice de réfraction ou elle peut être constituée de plusieurs strates (empilement), notamment un empilement de couches de matériau diélectrique alternant des couches à bas et haut indices de réfraction et se terminant par une couche à bas indice de réfraction.

Selon un autre mode de réalisation, la feuille de verre est revêtue d'au moins une couche mince transparente et conductrice de l'électricité sur une première face et d'au moins une couche antireflet sur l'autre face.

Du fait des propriétés de piégeage de la lumière de sa face munie de la texturation 1, la feuille de verre selon l'invention convient particulièrement comme substrat couvercle d'éléments destinés à utiliser le rayonnement solaire, comme par exemple des cellules photo-électriques. Il est également décrit un ensemble comprenant :
(i) une feuille de verre selon l'invention, et
(ii) au moins un élément capable d'utiliser un rayonnement incident traversant la feuille,
la feuille et ledit élément étant disposés sensiblement parallèlement entre eux, la face munie de la texturation 1 étant du côté de la feuille opposé audit élément et la distance entre la feuille et l'élément étant inférieure à 20 cm.

L'élément capable d'utiliser un rayonnement incident traversant la feuille peut être une cellule photoélectrique. Dans ce cas, la cellule photoélectrique est encapsulées dans une résine (par exemple, de l'EVA). La cellule photoélectrique peut comprendre avantageusement un substrat en silicium polycristallin.

Finalement, l'invention a également pour objet l'utilisation de la feuille de verre texturée selon l'invention comme substrat couvercle pour au moins un élément destiné à utiliser le rayonnement solaire.

La feuille de verre selon l'invention peut également être utilisée pour d'autres applications telles que les écrans acoustiques, les diffuseurs lumineux, le photovoltaïque intégré aux bâtiments, le photovoltaïque en film mince...

Les exemples qui suivent illustrent l'invention, sans intention de limiter de quelque façon sa couverture.

### Exemple 1

Une feuille de verre (exemple 1 selon l'invention), de dimensions 1640 x 980 mm, a été obtenue dans une installation destinée à fabriquer de manière continue du verre plat imprimé de type silico-sodo-calcique. Cette installation comprend un four de fusion, une lamineuse et une galerie de refroidissement. Le verre, à l'état fondu, a été coulé sous forme de ruban provenant du four de fusion dans la lamineuse où il est passé entre deux rouleaux superposés dont l'un est gravé selon le négatif des motifs de la texturation 1 et l'autre est gravé selon le négatif des motifs de la texturation 2. Le ruban de verre, une fois passé au travers de la lamineuse, a ensuite défilé vers la galerie de refroidissement.

La composition du verre utilisée est la suivante :
SiO₂ : 71,4%
Al₂O₃ : 0,615%
Na₂O : 14,13%
K₂O : 0,038%
CaO : 9,02%
MgO: 4,24%
SO₃: 0,344%
Fe₂O₃: 0,012%
Sb₂O₃: 0,1919%
TiO₂: 0,013%

Les motifs imprimés pour cette première feuille sont des prismes triangulaires pour les deux texturations et la feuille de verre obtenue a une épaisseur e de 4,2 mm. La hauteur h₁ des motifs de la texturation 1 est de 0,25 mm et le rapport R₁ (hauteur h₁ des motifs/épaisseur e de la feuille de verre) est donc de 0,06. La hauteur h₂ des motifs de la texturation 2 est de 0,2 mm. Le nombre n₁ de motifs de la texturation 1 est de 813. Le nombre n₂ de motifs de la texturation 2 est de 163. Tous les motifs de la texturation 2 sont isolés et espacés d'une distance de 6 mm. Leur base b₂ est de 1,2 mm.

Similairement, une autre feuille de verre (exemple comparatif) de même composition et de même taille a été obtenue dans une installation destinée à fabriquer de manière continue du verre plat imprimé de type silico-sodo-calcique identique. Le verre, à l'état fondu, a été coulé sous forme de ruban provenant du four de fusion dans la lamineuse où il est passé entre deux rouleaux superposés dont l'un est gravé selon le négatif des motifs de la texturation 1 et l'autre est lisse. Le ruban de verre, une fois passé au travers de la lamineuse, a ensuite défilé vers la galerie de refroidissement.

Les motifs imprimés pour cette deuxième feuille sont des prismes triangulaires et la feuille de verre obtenue a une épaisseur e de 4,2 mm. La hauteur h₁ des motifs de la texturation 1 est de 0,25 mm et le rapport R₁ (hauteur h₁ des motifs/épaisseur e de la feuille de verre) est donc de 0,06. Le nombre n₁ de motifs de la texturation 1 est de 813.

Ces deux feuilles de verre ont ensuite été trempées dans les mêmes conditions et de manière connue en soi, c'est-à-dire qu'elles ont été chauffées quelques instant au-dessus de leur point de transition vitreuse. Elles ont ensuite subi un refroidissement très rapide jusqu'à température ambiante. Plusieurs types de paramètres de trempe (courbe de chauffe, soufflage) ont été utilisés lors de différents tests (conditions a, b et c).

La déformation du verre a ensuite été évaluée via la mesure de la flèche/la déformation selon les deux dimensions principales. Dans tous les cas, on observe que la feuille de verre ne comportant que la texturation 1 (exemple comparatif) est davantage déformée par la trempe que la feuille de verre de l'exemple 1 comprenant la texturation 1 sur une face et la texturation 2 sur l'autre, selon l'invention. Les différences de déformations observées (delta entre l'exemple 1 selon l'invention et l'exemple comparatif texturé uniquement sur une face) sont présentées dans le tableau suivant.

Dans chacun des cas a, b et c, la fragmentation a également été vérifiée, et satisfait aux standards.

| | **Delta Déformation axe 1 [mm/m]** | **Delta Déformation axe 2 [mm/m]** |
|---|---|---|
| **Exemple 1a** | -1,3 | -1,5 |
| **Exemple 1b** | -1,7 | -0,7 |
| **Exemple 1c** | -0,9 | -0,7 |

### Exemple 2

Une feuille de verre (exemple 2 selon l'invention) de dimensions 1674 x 984 mm, a été obtenue dans une installation destinée à fabriquer de manière continue du verre plat imprimé de type silico-sodo-calcique. Cette installation comprend un four de fusion, une lamineuse et une galerie de refroidissement. Le verre, à l'état fondu, a été coulé sous forme de ruban provenant du four de fusion dans la lamineuse où il est passé entre deux rouleaux superposés dont l'un est gravé selon le négatif des motifs de la texturation 1 et l'autre est gravé selon le négatif des motifs de la texturation 2. Le ruban de verre, une fois passé au travers de la lamineuse, a ensuite défilé vers la galerie de refroidissement.

La composition du verre utilisée est la même que celle de l'exemple 1.

Les motifs imprimés sont des prismes triangulaires pour les deux texturations et la feuille de verre obtenue a une épaisseur e de 3,16 mm. La hauteur h₁ des motifs de la texturation 1 est de 0,37 mm et le rapport R₁ (hauteur h₁ des motifs/épaisseur e de la feuille de verre) est donc de 0,12. La hauteur h₂ des motifs de la texturation 2 est de 0,45 mm. Le nombre n₁ de motifs de la texturation 1 est de 820. Le nombre n₂ de motifs de la texturation 2 est de 164. Tous les motifs de la texturation 2 sont isolés et espacés d'une distance de 6 mm. Leur base b₂ est de 1,6 mm.

La feuille de verre a ensuite été trempée de la même manière que pour l'exemple 1 et a subi un même refroidissement très rapide jusqu'à température ambiante. Deux types de paramètres de trempe (courbe de chauffe, soufflage) ont été utilisés lors de différents tests (conditions a et b).

Dans ce deuxième exemple, la déformation a également été évaluée par la mesure de la flèche/la déformation selon les deux dimensions principales de la feuille de verre. Les valeurs résumées dans le tableau ci-dessous font apparaitre que la déformation est très fortement limitée, et se situe soit bien en dessous soit à la limite de la tolérance de 3 mm/m.

La fragmentation a également été vérifiée et satisfait aux standards.

| | **Déformation axe 1 [mm/m]** | **Déformation axe 2 [mm/m]** |
|---|---|---|
| **Exemple 2a** | 3 | 1 |
| **Exemple 2b** | 1 | 3 |

### Exemple 3 - test de découpe et de manutention

Une feuille de verre (exemple 3 selon l'invention) de dimensions 1674 x 984 mm, a été obtenue dans une installation destinée à fabriquer de manière continue du verre plat imprimé de type silico-sodo-calcique. Cette installation comprend un four de fusion, une lamineuse et une galerie de refroidissement. Le verre, à l'état fondu, a été coulé sous forme de ruban provenant du four de fusion dans la lamineuse où il est passé entre deux rouleaux superposés dont l'un est gravé selon le négatif des motifs de la texturation 1 et l'autre est gravé selon le négatif des motifs de la texturation 2. Le ruban de verre, une fois passé au travers de la lamineuse, a ensuite défilé vers la galerie de refroidissement,

La composition du verre utilisée est la même que celle de l'exemple 1.

Les motifs imprimés pour cette feuille sont des prismes triangulaires pour les texturations 1 et 2 et la feuille de verre obtenue a une épaisseur e de 4,2 mm. La hauteur h₁ des motifs de la texturation 1 est de 0,25 mm et le rapport R₁ (hauteur h₁ des motifs/épaisseur e de la feuille de verre) est donc de 0,06. La hauteur h₂ des motifs de la texturation 2 est de 0,2 mm. Le nombre n₁ de motifs de la texturation 1 est de 813. Le nombre n₂ de motifs de la texturation 2 est de 163. Tous les motifs de la texturation 2 sont isolés et espacés d'une distance de 6 mm. Leur base b₂ est de 1,2 mm.

Une autre feuille de verre (exemple comparatif) de même composition et de même taille a été obtenue de la même manière que la première. Les motifs imprimés pour cette seconde feuille sont également des prismes triangulaires pour les texturations 1 et 2 et la feuille de verre obtenue a une épaisseur e de 4,2 mm. La hauteur h₁ des motifs de la texturation 1 est de 0,25 mm et le rapport R₁ (hauteur h₁ des motifs/épaisseur e de la feuille de verre) est donc de 0,06. Identiquement, la hauteur h₂ des motifs de la texturation 2 est de 0,25 mm. Le nombre n₁ de motifs de la texturation 1 est de 813. Le nombre n₂ de motifs de la texturation 2 est également de 813 (n₁=n₂). Tous les motifs de la texturation 2 sont espacés d'une distance de 1,2 mm et leur base b₂ est de 1,2 mm (ce qui signifie que les motifs sont jointifs).

Ces deux feuilles de verre ont ensuite été découpées de manière connue en soi, à l'aide d'une roulette de verrier utilisée pour rayer un trait de découpe sur la face de la texturation 2 Deux essais ont été réalisés : dans le premier, le trait de découpe est parallèle à l'axe de la texturation 2 et dans le second, le trait de découpe est perpendiculaire à l'axe de la texturation 2. Pour chaque essai, deux angles de roulette ont été testés (130° et 110°) et ont donnés des résultats comparables. Finalement, ces deux feuilles de verre ont ensuite manipulées à l'aide d'un préhenseur automatique équipé de ventouses de levage développant une dépression de 400 mbar appliquées sur la face de la texturation 2.

Les résultats de ces différents tests sont présentés dans le tableau ci-dessous qui montre que les problèmes de découpe et de préhension liés à la présence de la texturation 2 de l'exemple comparatif ont pu être résolus en utilisant la texturation 2 selon l'invention.

| | **Exemple 2 selon l'invention** | **Exemple comparatif** |
|---|---|---|
| **Découpe parallèle à la texturation 2** | **OK** | **KO** |
| **Découpe perpendiculaire à la texturation 2** | **OK** | **KO** |
| **Préhension (ventouse sur la face de la texturation 2)** | **OK** | **KO** |

## Revendications

1. Feuille de verre transparente comprenant :
- une première face munie d'une texturation (1) formée dans la masse du verre par une pluralité de motifs géométriques en relief, convexes par rapport au plan général de ladite face, rectilignes et parallèles entre eux s'étendant tout le long de ladite face et répartis sur l'ensemble de ladite face, et
- une seconde face munie d'une texturation (2) formée dans la masse du verre par une pluralité de motifs géométriques en relief, concaves par rapport au plan général de ladite face, rectilignes et parallèles entre eux s'étendant tout le long de ladite face et répartis sur l'ensemble de ladite face,
**caractérisée en ce que** les motifs de la texturation (2) sont tels que :
(i) le rapport de la hauteur h₂ des motifs de la texturation (2) sur la dimension b₂ de leur base est compris entre 0,05 ≤h₂/b₂ ≤ 2 ;
(ii) le rapport de la hauteur h₂ des motifs de la texturation (2) sur la hauteur h₁ des motifs de la texturation (1) est tel que 0,5 ≤ h₂/h₁ ≤ 2 ;
(iii) le rapport du nombre n₂ de motifs de la texturation (2) sur le nombre n₁ de motifs de la texturation (1) est tel que n₂/n₁ ≥ 0,1 et n₂/n₁ ≤ 0.5.

2. Feuille de verre transparente selon la revendication précédente, **caractérisée en ce que** le rapport de la hauteur h₂ des motifs de la texturation (2) sur la dimension b₂ de leur base est compris entre 0,1 ≤ h₂/b₂ ≤ 1.

3. Feuille de verre transparente selon la revendication précédente, **caractérisée en ce que** le rapport de la hauteur h₂ des motifs de la texturation (2) sur la hauteur h₁ des motifs de la texturation (1) est tel que 0,5 ≤ h₂/h₁ ≤ 1.

4. Feuille de verre transparente selon l'une des revendications précédentes, **caractérisée en ce que** le rapport du nombre n₂ de motifs de la texturation (2) sur le nombre n₁ de motifs de la texturation (1) est tel que n₂/n₁ ≥ 0,2.

5. Feuille de verre transparente selon l'une des revendications précédentes, **caractérisée en ce que** le rapport du nombre n₂ de motifs de la texturation (2) sur le nombre n₁ de motifs de la texturation (1) est tel que n₂/n₁ ≤ 0,3.

6. Feuille de verre transparente selon l'une des revendications précédentes, **caractérisée en ce que** le rapport R₁ de la hauteur h₁ des motifs de la texturation (1) sur l'épaisseur e de la feuille de verre est tel que 0,1 < R₁ ≤ 0,30.

7. Feuille de verre transparente selon l'une des revendications précédentes, **caractérisée en ce que** l'axe des motifs rectilignes de la texturation (1) forme un angle inférieur à 30° avec l'axe des motifs rectilignes de la texturation (2).

8. Feuille de verre transparente selon l'une des revendications précédentes, **caractérisée en ce que** les motifs géométriques de la texturation (1) sont jointifs.

9. Feuille de verre transparente selon l'une des revendications précédentes, **caractérisée en ce qu'**elle est revêtue d'au moins une couche antireflet.

10. Utilisation d'une feuille selon l'une des revendications de feuille précédentes, comme substrat couvercle pour au moins un élément destiné à utiliser le rayonnement solaire.

## Patentansprüche

1. Transparente Glasscheibe, umfassend:
eine erste Fläche, ausgestattet mit einer Struktur (1), die in der Masse des Glases anhand einer Vielzahl von geometrischen, in Bezug auf die allgemeine Ebene der Fläche konvexen, geradlinigen und zueinander parallelen Reliefmotiven gebildet ist, die sich über die gesamte Länge der Fläche erstrecken und auf der gesamten Fläche verteilt sind, und
eine zweite Fläche, ausgestattet mit einer Struktur (2), die in der Masse des Glases anhand einer Vielzahl von geometrischen, in Bezug auf die allgemeine Ebene der Fläche konkaven, geradlinigen und zueinander parallelen Reliefmotiven gebildet ist, die sich über die gesamte Länge der Fläche erstrecken und auf der gesamten Fläche verteilt sind,
**dadurch gekennzeichnet, dass** die Motive der Struktur (2) derart sind, dass:
(i) das Verhältnis der Höhe h₂ der Motive der Struktur (2) zu der Abmessung b₂ ihrer Basis zwischen 0,05 ≤ h₂/b₂ ≤ 2 beträgt,
(ii) das Verhältnis der Höhe h₂ der Motive der Struktur (2) zu der Höhe h₁ der Motive der Struktur (1) derart ist, dass 0,5 ≤ h₂/h₁ ≤ 2 ist,
(iii) das Verhältnis der Anzahl n₂ von Motiven der Struktur (2) zu der Anzahl n₁ von Motiven der Struktur (1) derart ist, dass n₂/n₁ ≥ 0,1 und n₂/n₁ ≤ 0,5 ist.

2. Transparente Glasscheibe nach vorangehendem Anspruch, **dadurch gekennzeichnet, dass** das Verhältnis der Höhe h2 der Motive der Struktur (2) zu der Abmessung b2 ihrer Basis zwischen 0,1 ≤ h2/b2 ≤ 1 beträgt.

3. Transparente Glasscheibe nach vorangehendem Anspruch, **dadurch gekennzeichnet, dass** das Verhältnis der Höhe h2 der Motive der Struktur (2) zu der Höhe h1 der Motive der Struktur (1) derart ist, dass 0,5 ≤ h2/h1 ≤ 1 ist.

4. Transparente Glasscheibe nach einem der vorangehenden Ansprüche, **dadurch gekennzeichnet, dass** das Verhältnis der Anzahl n2 von Motiven der Struktur (2) zu der Anzahl n1 von Motiven der Struktur (1) derart ist, dass n2/n1 ≥ 0,2 ist.

5. Transparente Glasscheibe nach einem der vorangehenden Ansprüche, **dadurch gekennzeichnet, dass** das Verhältnis der Anzahl n2 von Motiven der Struktur (2) zu der Anzahl n1 von Motiven der Struktur (1) derart ist, dass n2/n1 ≤ 0,3 ist.

6. Transparente Glasscheibe nach einem der vorangehenden Ansprüche, **dadurch gekennzeichnet, dass** das Verhältnis R1 der Höhe h1 der Motive der Struktur (1) zu der Stärke e der Glasscheibe derart ist, dass 0,1 < R1 ≤ 0,30 ist.

7. Transparente Glasscheibe nach einem der vorangehenden Ansprüche, **dadurch gekennzeichnet, dass** die Achse der geradlinigen Motive der Struktur (1) einen Winkel kleiner als 30° mit der Achse der geradlinigen Motive der Struktur (2) bildet.

8. Transparente Glasscheibe nach einem der vorangehenden Ansprüche, **dadurch gekennzeichnet, dass** sich die geometrischen Motive der Struktur (1) berühren.

9. Transparente Glasscheibe nach einem der vorangehenden Ansprüche, **dadurch gekennzeichnet, dass** sie mit mindestens einer Antireflexschicht beschichtet ist.

10. Verwendung einer Scheibe nach einem der vorangehenden Scheibenansprüche als Deckelsubstrat für mindestens ein Element, das zur Verwendung der Sonnenstrahlung bestimmt ist.

## Claims

1. Transparent glass sheet, comprising:
- a first face provided with a texture (1) formed in the bulk of the glass by a plurality of three-dimensional geometric motifs that are convex relative to the general plane of said face, rectilinear and parallel to one another, said motifs extending all the way along said face and being distributed over the entirety of said face; and
- a second face provided with a texture (2) formed in the bulk of the glass by a plurality of three-dimensional geometric motifs that are concave relative to the general plane of said face, rectilinear and parallel to one another, said motifs extending all the way along said face and being distributed over the entirety of said face,
**characterized in that** the motifs of the texture (2) are such that:
(i) the ratio of the height h₂ of the motifs of the texture (2) to the size b₂ of their base is comprised between 0.05 ≤ h₂/b₂ ≤ 2;
(ii) the ratio of the height h₂ of the motifs of the texture (2) to the height h₁ of the motifs of the texture (1) is such that 0.5 ≤ h₂/h₁ ≤ 2; and
(iii) the ratio of the number n₂ of motifs of the texture (2) to the number n₁ of motifs of the texture (1) is such that n₂/n₁ ≥ 0.1 and n₂/n₁ ≤ 0.5.

2. Transparent glass sheet according to the preceding claim, **characterized in that** the ratio of the height h₂ of the motifs of the texture (2) to the size b₂ of their base is comprised between 0.1 ≤ h₂/b₂ ≤ 1.

3. Transparent glass sheet according to the preceding claim, **characterized in that** the ratio of the height h2 of the motifs of the texture (2) to the height h1 of the motifs of the texture (1) is such that 0.5 ≤ h2/h1 ≤ 1.

4. Transparent glass sheet according to one of the preceding claims, **characterized in that** the ratio of the number n2 of motifs of the texture (2) to the number n1 of motifs of the texture (1) is such that n2/n1 ≥ 0.2.

5. Transparent glass sheet according to one of the preceding claims, **characterized in that** the ratio of the number n2 of motifs of the texture (2) to the number n1 of motifs of the texture (1) is such that n2/n1 ≤ 0.3.

6. Transparent glass sheet according to one of the preceding claims, **characterized in that** the ratio R1 of the height h1 of the motifs of the texture (1) to the thickness e of the glass sheet is such that 0.1 < R1 ≤ 0.30.

7. Transparent glass sheet according to one of the preceding claims, **characterized in that** the axis of the rectilinear motifs of the texture (1) makes an angle smaller than 30° to the axis of the rectilinear motifs of the texture (2).

8. Transparent glass sheet according to one of the preceding claims, **characterized in that** the geometric motifs of the texture (1) are contiguous.

9. Transparent glass sheet according to one of the preceding claims, **characterized in that** it is coated with at least one antireflection layer.

10. Use of a sheet according to one of the preceding sheet claims as a cover substrate for at least one component intended to use solar radiation.
